(19) **Europäisches Patentamt / European Patent Office / Office européen des brevets**

(11) **EP 3 070 462 B1**

(12) **FASCICULE DE BREVET EUROPEEN**

(45) Date de publication et mention de la délivrance du brevet:
**28.02.2018 Bulletin 2018/09**

(51) Int Cl.:
**G01N 27/04** *(2006.01)* **G01N 27/72** *(2006.01)*
**G01R 31/26** *(2014.01)*

(21) Numéro de dépôt: **16160279.2**

(22) Date de dépôt: **15.03.2016**

(54) **DISPOSITIF ET PROCEDE DE DETECTION D'UNE INHOMOGENEITE MAGNETIQUE DANS UN MATERIAU FERROMAGNETIQUE**

VORRICHTUNG UND VERFAHREN ZUR DETEKTION EINER MAGNETISCHEN INHOMOGENITÄT IN EINEM FERROMAGNETISCHEN MATERIAL

DEVICE AND METHOD FOR DETECTING A MAGNETIC INHOMOGENEITY IN A FERROMAGNETIC MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.03.2015 FR 1552302**

(43) Date de publication de la demande:
**21.09.2016 Bulletin 2016/38**

(73) Titulaires:
- **COMMISSARIAT À L'ÉNERGIE ATOMIQUE ET AUX ÉNERGIES ALTERNATIVES**
  **75015 Paris (FR)**
- **Université Grenoble Alpes**
  **38041 Grenoble Cedex 09 (FR)**

(72) Inventeurs:
- **ATTANE, Jean-Philippe**
  **38100 GRENOBLE (FR)**
- **SAVERRO TORRES, Williams**
  **SANTA ANITA LIMA (PE)**
- **VILA, Laurent**
  **38000 GRENOBLE (FR)**
- **MARTY, Alain**
  **38650 SAINT MARTIN DE LA CLUZE (FR)**

(74) Mandataire: **Cabinet Camus Lebkiri**
**25 rue de Maubeuge**
**75009 Paris (FR)**

(56) Documents cités:
**US-A1- 2003 117 750**

- **K. WANG ET AL: "Tunneling anisotropic magnetoresistance in Co/AlOx/Al tunnel junctions with fcc Co (111) electrodes", PHYSICAL REVIEW. B, CONDENSED MATTER AND MATERIALS PHYSICS, vol. 88, no. 5, 1 août 2013 (2013-08-01), XP055248071, US ISSN: 1098-0121, DOI: 10.1103/PhysRevB.88.054407**
- **GOULD C ET AL: "Tunneling Anisotropic Magnetoresistance: A Spin-Valve-Like Tunnel Magnetoresistance Using a Single Magnetic Layer", PHYSICAL REVIEW LETTERS, AMERICAN PHYSICAL SOCIETY, US, vol. 93, no. 11, 9 septembre 2004 (2004-09-09), pages 117203-1, XP002475020, ISSN: 0031-9007**

**EP 3 070 462 B1**

**Description**

**DOMAINE TECHNIQUE DE L'INVENTION**

Le domaine technique de l'invention est celui de l'électronique de spin, ou spintronique. Un aspect de la présente invention concerne un dispositif de détection d'une inhomogénéité magnétique dans un matériau ferromagnétique. Un autre aspect de la présente invention concerne un procédé de détection d'une inhomogénéité magnétique dans un matériau ferromagnétique. Les domaines principaux d'application de l'invention sont par exemple les capteurs de champ magnétiques, les mémoires magnétiques et les systèmes logiques magnétiques.

**ARRIERE-PLAN TECHNOLOGIQUE DE L'INVENTION**

Une magnétorésistance est une variation de la résistance d'un dispositif en fonction du champ magnétique appliqué à ce dispositif. L'effet de magnétorésistance est généralement lié à la modification de l'orientation de moments magnétiques dans un élément ferromagnétique. Il est ainsi connu d'exploiter l'effet de magnétorésistance pour réaliser un capteur de champ magnétique. Il est également connu de réaliser des têtes de lecture de disques durs utilisant l'effet de magnétorésistance : des bits d'information, magnétiques, génèrent à l'extérieur du disque dur un champ magnétique, qui est mesuré par une tête de lecture placée à proximité du disque dur, via un effet de magnétorésistance. L'effet de magnétorésistance peut aussi être utilisé pour la lecture de points mémoires ou logiques : on considère un élément ferromagnétique dont les moments magnétiques peuvent prendre une première orientation associée à une première résistance, ou une deuxième orientation distincte de la première orientation et associée à une deuxième résistance distincte de la première résistance. Les première et deuxième orientations correspondent alors aux états logiques « 0 » et « 1 ». Il s'agit d'un des principes de base des mémoires MRAM (de l'anglais « Magnetic Random Access Memory »).
Une modification de l'orientation de moments magnétiques peut être réalisée par l'application d'un champ magnétique, mais également par l'application d'un courant : il s'agit de l'effet de transfert de spin, qui est par exemple mis en oeuvre dans les mémoires STT-MRAM (de l'anglais « Spin-Transfer Torque MRAM »). Une modification de la résistance d'un élément peut donc être observée en l'absence d'application d'un champ magnétique. Le terme de magnétorésistance est toutefois également employé, pour décrire une dépendance de la résistance d'un élément ferromagnétique en fonction de l'orientation des moments magnétiques dans l'élément ferromagnétique.
Plusieurs formes de magnétorésistances peuvent être distinguées.

- La magnétorésistance géante GMR (« giant magnetoresistance » en anglais) met en oeuvre un empilement de deux couches ferromagnétiques séparées par une couche non magnétique. La magnétorésistance tunnel TMR (« tunnel magnetoresistance » en anglais) met également en oeuvre un empilement de deux couches ferromagnétiques, séparées cette fois par une couche isolante. Dans les deux cas, la résistance de ces empilements varie avec l'orientation relative des aimantations des couches ferromagnétiques. Lorsque les deux couches ferromagnétiques ont une aimantation parallèle, la résistance est faible. Lorsque les deux couches ferromagnétiques ont une aimantation antiparallèle, la résistance est forte.
- La magnétorésistance anisotrope AMR (« anisotropic magnetoresistance » en anglais) est la propriété d'un élément ferromagnétique simple à présenter une résistance qui dépend de l'orientation relative de son aimantation par rapport au courant qui le traverse.
- La magnétorésistance de paroi DWR (« Domain Wall Résistance » en anglais) est la propriété d'un élément ferromagnétique simple à présenter une variation locale de résistivité en présence d'une paroi magnétique.

Les dispositifs basés sur un élément ferromagnétique simple, qui utilisent les effets de magnétorésistance anisotrope AMR ou de paroi DWR n'ont que de faibles variations de résistance : typiquement de l'ordre de quelques Ohms, soit une variation relative de résistance typiquement inférieure à 10%. Leur utilisation est par conséquent limitée. Les dispositifs qui utilisent les effets de magnétorésistance géante GMR ou tunnel TMR présentent d'importantes variations de résistance, mais le fait que ces dispositifs comportent au moins deux couches ferromagnétiques, susceptibles d'interagir par un couplage, peut limiter leurs possibilités d'application.
La configuration d'un élément ferromagnétique est dite inhomogène si les moments magnétiques de l'élément ferromagnétique ne sont pas orientés de la même manière en tout point de l'élément ferromagnétique. Un élément ferromagnétique ayant une configuration inhomogène comporte typiquement plusieurs domaines magnétiques, chaque domaine magnétique ayant des moments magnétiques alignés dans une même direction, les domaines magnétiques étant séparés entre eux par des parois magnétiques à l'intérieur desquelles les moments magnétiques tournent graduellement. Les inhomogénéités magnétiques, telles que les parois magnétiques, peuvent être utilisées pour réaliser des capteurs ou des dispositifs logiques ou mémoires. Ainsi un capteur de champ magnétique peut utiliser la déformation ou le déplacement d'une paroi magnétique en fonction d'un champ magnétique appliqué. Pour un dispositif logique ou mémoire, la position d'une paroi magnétique, c'est-à-dire sa présence ou son absence en un point donné, peut constituer le bit élémentaire d'information.

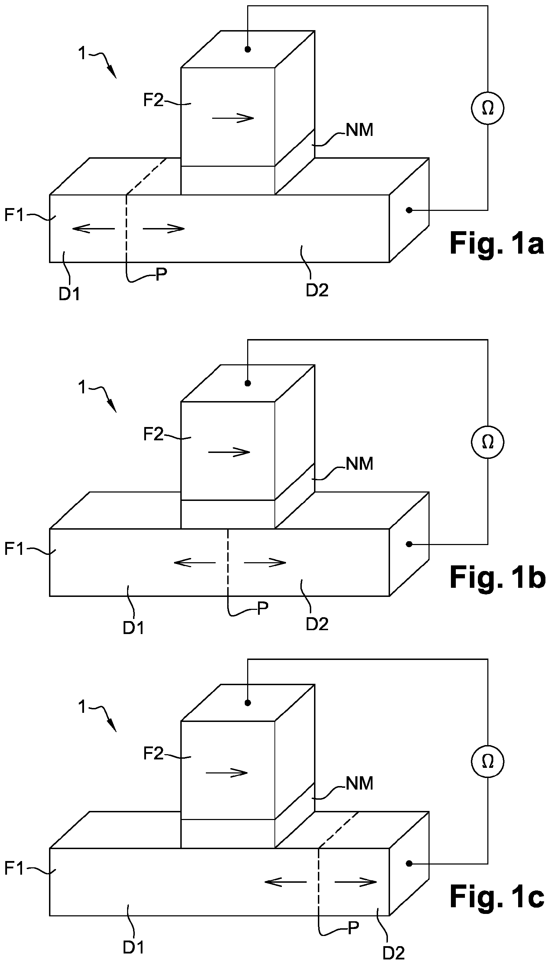

Les figures 1a, 1b et 1c montrent schématiquement le principe de la détection d'une inhomogénéité magnétique de type paroi magnétique dans un élément ferromagnétique par une mesure de magnétorésistance géante GMR ou tunnel TMR selon l'état de la technique. Les figures 1a, 1b et 1c sont décrites conjointement et montrent un dispositif 1 de détection d'une paroi magnétique dans un élément ferromagnétique par une mesure de magnétorésistance géante GMR ou tunnel TMR. Le dispositif 1 comporte :

- un premier élément ferromagnétique F1 présentant une aimantation variable et un deuxième élément ferromagnétique F2 présentant une aimantation fixe ;
- un élément non magnétique NM séparant le premier élément ferromagnétique F1 du deuxième élément ferromagnétique F2. Lorsque le dispositif 1 utilise une mesure de magnétorésistance géante GMR, l'élément non magnétique NM est conducteur. Lorsque le dispositif 1 utilise une mesure de magnétorésistance tunnel TMR, l'élément non magnétique NM est isolant ;
- un premier contact électrique sur le premier élément ferromagnétique et un deuxième contact électrique sur le deuxième élément ferromagnétique ;
- des moyens pour appliquer une tension entre le premier contact électrique et le deuxième contact électrique, et des moyens pour mesurer la résistance électrique de l'empilement formé par le premier élément ferromagnétique F1, l'élément non magnétique NM et le deuxième élément ferromagnétique F2.

L'aimantation du premier élément ferromagnétique F1 est variable par exemple en fonction d'un champ magnétique appliqué au dispositif 1. Le premier élément ferromagnétique F1 présente ainsi :

- un premier domaine magnétique D1 dans lequel les moments magnétiques sont tous alignés dans une première direction,
- un deuxième domaine magnétique D2 dans lequel les moments magnétiques sont tous alignés dans une deuxième direction distincte de la première direction,
- une paroi magnétique P séparant le premier domaine magnétique D1 du deuxième domaine magnétique D2. A l'intérieur de la paroi magnétique P, l'orientation des moments magnétiques varie progressivement pour passer de la première direction du premier domaine à la deuxième direction du deuxième domaine.

La figure 1a montre une première configuration du dispositif 1, selon laquelle la paroi magnétique P du premier élément ferromagnétique F1 est positionnée de telle sorte que le deuxième domaine magnétique D2 prédomine. Le deuxième domaine magnétique D2 du premier élément ferromagnétique F1 et le deuxième élément ferromagnétique F2 présentent des aimantations parallèles, et l'empilement présente une première résistance R1.

La figure 1b montre une deuxième configuration du dispositif 1, selon laquelle la paroi magnétique P du premier élément ferromagnétique F1 est positionnée de telle sorte qu'aucun des premier et deuxième domaines magnétiques D1 et D2 ne prédomine. L'empilement présente une deuxième résistance R2, supérieure à la première résistance R1.

La figure 1c montre une troisième configuration du dispositif 1, selon laquelle la paroi magnétique P du premier élément ferromagnétique F1 est positionnée de telle sorte que le premier domaine magnétique D1 prédomine. Le premier domaine magnétique D1 du premier élément ferromagnétique F1 et le deuxième élément ferromagnétique F2 présentent des aimantations antiparallèles, et l'empilement présente une troisième résistance R3, qui est supérieure à la deuxième résistance R2 et à la première résistance R1.

## RESUME DE L'INVENTION

Un aspect de l'invention vise à proposer un dispositif permettant de détecter une inhomogénéité magnétique dans un matériau ferromagnétique grâce à une variation de résistance supérieure à celle des dispositifs utilisant des effets de magnétorésistance anisotrope AMR ou de paroi DWR, et tout en n'étant pas sujet aux problématiques de couplage ou de champ de fuite pouvant affecter les dispositifs utilisant des effets de magnétorésistance géante GMR ou tunnel TMR. Un autre aspect de l'invention vise à proposer un dispositif alternatif permettant de lire une information stockée dans une position ou dans une configuration d'une inhomogénéité magnétique dans un matériau ferromagnétique.

Un aspect de l'invention concerne donc un dispositif de détection d'une inhomogénéité magnétique dans un matériau ferromagnétique comportant :

- une première couche barrière en matériau oxydé s'étendant sensiblement suivant un plan de référence et apte à être agencée au contact d'au moins une partie d'une couche du matériau ferromagnétique ;

- une première couche d'un matériau non ferromagnétique déposée sur la première couche barrière et s'étendant sensiblement parallèlement au plan de référence ;
- des moyens pour appliquer un courant traversant sensiblement perpendiculairement au plan de référence l'empilement formé par la couche du matériau ferromagnétique, la première couche barrière et la première couche d'un matériau non ferromagnétique ;
- des moyens pour mesurer la résistance électrique dudit empilement.

Grâce à l'invention :

- lorsqu'une inhomogénéité magnétique est présente dans la au moins une partie de la couche du matériau ferromagnétique au contact de laquelle la première couche barrière est agencée, les moyens de mesure de la résistance électrique de l'empilement permettent de mesurer, lorsqu'un premier courant traverse l'empilement sensiblement perpendiculairement au plan de référence, une première résistance, et
- lorsqu'aucune inhomogénéité magnétique n'est présente ou lorsque la configuration magnétique de l'inhomogénéité est différente dans la au moins une partie de la couche du matériau ferromagnétique au contact de laquelle la première couche barrière est agencée, les moyens de mesure de la résistance électrique de l'empilement permettent de mesurer, lorsqu'un deuxième courant - qui peut être égal au premier courant ou différent du premier courant - traverse l'empilement sensiblement perpendiculairement au plan de référence, une deuxième résistance qui est supérieure à la première résistance.

L'invention permet ainsi de détecter une inhomogénéité magnétique, telle qu'une paroi magnétique ou un skyrmion, dans une couche d'un matériau ferromagnétique grâce à une variation de résistance électrique. Le dispositif de détection selon un aspect de l'invention ne comporte pas de couche ferromagnétique, ce qui permet avantageusement d'éliminer tout risque de couplage avec la couche ferromagnétique dans laquelle on souhaite déterminer la présence ou l'absence d'une inhomogénéité magnétique. Dans le dispositif de détection selon un aspect de l'invention, il est expérimentalement constaté des variations de résistance électrique de l'ordre de 25% à 50%, selon la configuration du dispositif - qui peut comporter une ou plusieurs couches barrières. Lesdites variations de résistance électrique sont typiquement de l'ordre de plusieurs centaines d'Ohms, ce qui est supérieur aux variations de résistance électrique obtenues dans des dispositifs utilisant la magnétorésistance anisotrope AMR ou de paroi DWR, qui sont typiquement inférieures à 10% et de l'ordre du Ohm. Lorsque le dispositif de détection selon un aspect de l'invention est agencé au contact d'une couche ferromagnétique homogène, il se crée une accumulation de spin aux interfaces qui entraîne une résistance additionnelle de l'empilement formé par la couche ferromagnétique et le dispositif de sélection. Lorsque le dispositif de détection selon un aspect de l'invention est agencé au contact d'une couche ferromagnétique inhomogène, la résistance additionnelle disparaît.

Outre les caractéristiques qui viennent d'être évoquées dans le paragraphe précédent, le dispositif de détection d'une inhomogénéité magnétique dans un matériau ferromagnétique selon un aspect de l'invention peut présenter une ou plusieurs caractéristiques complémentaires parmi les suivantes, considérées individuellement ou selon toutes les combinaisons techniquement possibles :

- La première couche barrière est réalisée en oxyde de magnésium MgO ou en oxyde d'aluminium $Al_2O_3$ ou en oxyde d'hafnium $HfO_2$ ou en oxyde de titanate de strontium $SrTiO_3$..

- La couche du matériau ferromagnétique est réalisée en un alliage de cobalt, de fer et de bore CoFeB, ou en un alliage de cobalt et de fer CoFe, ou en cobalt Co, ou en un alliage de nickel et de fer NiFe.

- Alternativement, la couche du matériau ferromagnétique est une multicouche de type Co/Pt ou Co/Ni, ou un alliage de Heusler.

- La première couche d'un matériau non ferromagnétique présente une résistance supérieure ou égale à au moins 1% de la résistance de la première couche barrière

- La première couche d'un matériau non ferromagnétique présente avantageusement une résistance supérieure ou égale à au moins 10% de la résistance de la première couche barrière.

- Le dispositif de détection d'une inhomogénéité magnétique dans un matériau ferromagnétique comporte en outre :

    o une deuxième couche barrière déposée sur la première couche d'un matériau non ferromagnétique et s'étendant sensiblement parallèlement au plan de référence ;

o une deuxième couche d'un matériau non ferromagnétique déposée sur la deuxième couche barrière et s'étendant sensiblement parallèlement au plan de référence ;

o des moyens pour appliquer un courant traversant perpendiculairement la couche du matériau ferromagnétique, la première couche barrière, la première couche d'un matériau non ferromagnétique, la deuxième couche barrière et la deuxième couche d'un matériau non ferromagnétique.

Les inventeurs ont en effet constaté que, de manière surprenante, l'ajout d'une deuxième couche barrière et d'une deuxième couche d'un matériau non ferromagnétique sur la première couche barrière et la première couche d'un matériau non ferromagnétique permet, lors de l'introduction d'une inhomogénéité magnétique dans la couche du matériau ferromagnétique, d'amplifier la variation de résistance électrique de l'empilement formé par la couche du matériau ferromagnétique, la première couche barrière, la première couche d'un matériau non ferromagnétique, la deuxième couche barrière et la deuxième couche d'un matériau non ferromagnétique. Cette amplification permet avantageusement de détecter des inhomogénéités magnétiques qui ne sont pas détectables lorsque l'empilement ne comporte que la couche du matériau ferromagnétique, la première couche barrière et la première couche d'un matériau non ferromagnétique. Ce constat des inventeurs est surprenant dans la mesure où une variation de résistance électrique en fonction d'une variation d'orientation de l'aimantation est généralement expliquée par le phénomène de magnétorésistance anisotrope tunnel TAMR (« tunnel anisotropic magnetoresistance » en anglais) qui a lieu en particulier à l'interface entre une couche d'un matériau ferromagnétique et une couche barrière. Mais la deuxième couche barrière étant ici déposée sur la première couche d'un matériau non ferromagnétique, elle n'est pas en contact avec la couche d'un matériau ferromagnétique. Un homme du métier ne s'attend donc pas à ce qu'une deuxième couche barrière contribue au phénomène de magnétorésistance anisotrope tunnel TAMR. Un homme du métier s'attend au contraire à ce qu'une deuxième couche barrière, en ajoutant une résistance supplémentaire à l'empilement, dégrade la mesure qui est le rapport entre la variation de résistance et la résistance totale de l'empilement.

L'invention concerne également un procédé de détection d'une inhomogénéité magnétique dans un matériau ferromagnétique au moyen d'un dispositif de détection d'une inhomogénéité magnétique selon un aspect de l'invention, comportant les étapes suivantes :

- appliquer un courant traversant, sensiblement perpendiculairement au plan de référence, l'empilement formé par la couche du matériau ferromagnétique et le dispositif de détection d'une inhomogénéité magnétique ;
- mesurer la résistance dudit empilement ;
- comparer la résistance précédemment mesurée avec une résistance de référence, la résistance de référence étant la résistance dudit empilement en l'absence d'inhomogénéité magnétique dans la couche du matériau ferromagnétique ;
- détecter la présence d'une inhomogénéité magnétique dans la couche du matériau ferromagnétique si la résistance mesurée est inférieure à la résistance de référence.

Outre les caractéristiques évoquées dans le paragraphe précédent, le procédé de détection d'une inhomogénéité magnétique dans un matériau ferromagnétique selon un aspect de l'invention peut présenter la caractéristique complémentaire suivante :

- Le procédé de détection d'une inhomogénéité magnétique dans un matériau ferromagnétique comporte une étape d'agencement du dispositif de détection d'une inhomogénéité magnétique de manière que la première couche barrière du dispositif de détection d'une inhomogénéité magnétique s'étende au contact d'au moins une partie d'une couche du matériau ferromagnétique.

L'invention concerne également un procédé de détection d'une modification d'une configuration magnétique d'une inhomogénéité magnétique dans un matériau ferromagnétique au moyen d'un dispositif de détection d'une inhomogénéité magnétique selon un aspect, comportant les étapes suivantes :

- appliquer un courant traversant, sensiblement perpendiculairement au plan de référence l'empilement formé par la couche du matériau ferromagnétique et le dispositif de détection d'une inhomogénéité magnétique ;
- mesurer une première résistance dudit empilement à un premier instant et une deuxième résistance dudit empilement à un deuxième instant différent du premier instant ;
- comparer les première et deuxième résistances ;
- détecter une modification de la configuration magnétique de l'inhomogénéité magnétique si les première et deuxième résistances sont distinctes l'une de l'autre.

Outre les caractéristiques évoquées dans le paragraphe précédent, le procédé de détection d'une modification d'une configuration magnétique d'une inhomogénéité magnétique dans un matériau ferromagnétique selon un aspect de l'invention peut présenter la caractéristique complémentaire suivante :

- Le procédé de détection d'une modification d'une configuration magnétique d'une inhomogénéité magnétique dans un matériau ferromagnétique comporte une étape d'agencement du dispositif de détection d'une inhomogénéité magnétique de manière que la première couche barrière du dispositif de détection d'une inhomogénéité magnétique s'étende au contact d'au moins une partie d'une couche du matériau ferromagnétique.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1a montre schématiquement une première configuration d'un dispositif de détection d'une paroi magnétique dans un élément ferromagnétique par une mesure de magnétorésistance géante GMR ou tunnel TMR, selon l'état de la technique.
- La figure 1b montre schématiquement une deuxième configuration du dispositif de la figure 1a, selon l'état de la technique.
- La figure 1c montre schématiquement une troisième configuration du dispositif de la figure 1a, selon l'état de la technique.
- La figure 2a montre schématiquement une première configuration d'un dispositif de détection d'une inhomogénéité magnétique dans un élément ferromagnétique, selon un premier mode de réalisation de l'invention.

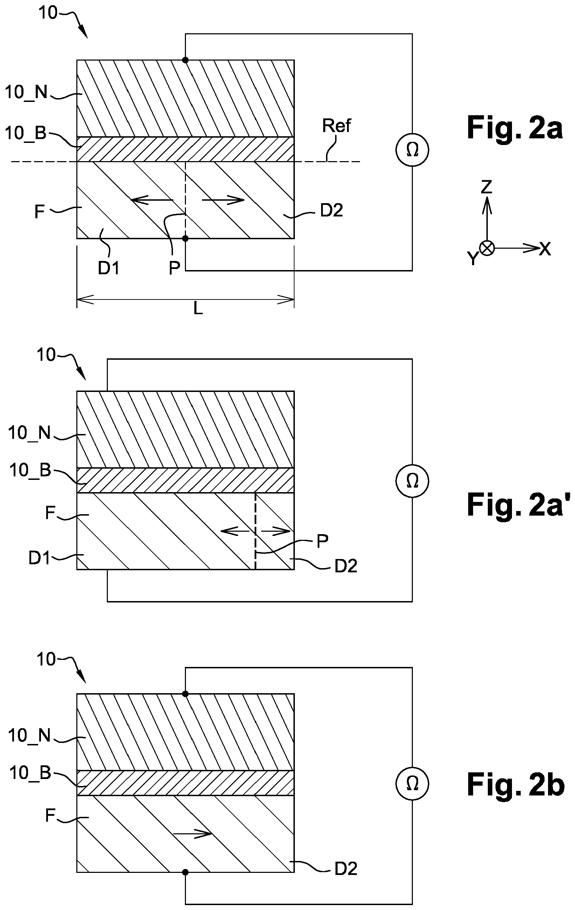

- La figure 2a' montre schématiquement une première configuration alternative du dispositif de la figure 2a, selon le premier mode de réalisation de l'invention.
- La figure 2b montre schématiquement une deuxième configuration du dispositif de la figure 2a, selon le premier mode de réalisation de l'invention.

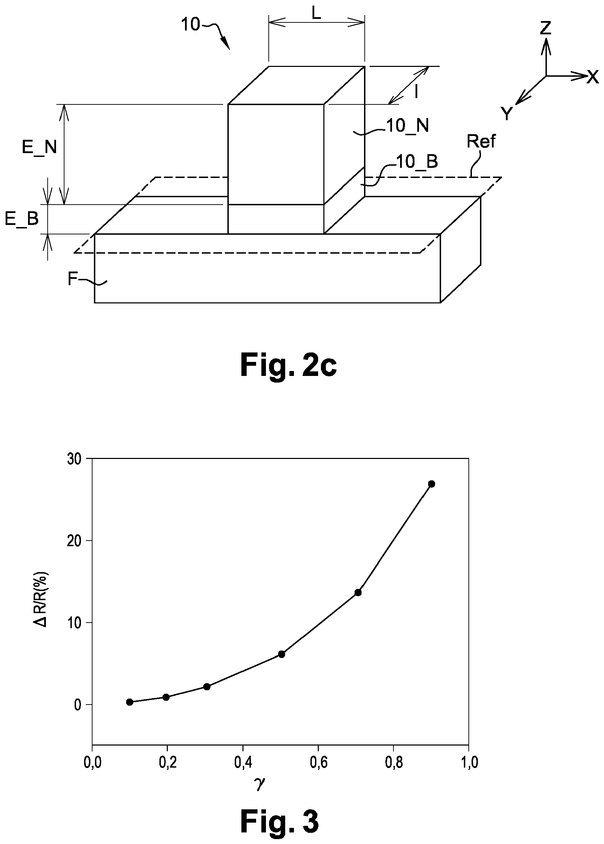

- La figure 2c montre schématiquement les dimensions typiques du dispositif de la figure 2a, selon le premier mode de réalisation de l'invention.
- La figure 3 montre une simulation numérique de l'évolution de la variation relative de la résistance d'un empilement formé par une couche ferromagnétique et un dispositif de détection d'une inhomogénéité magnétique selon le premier mode de réalisation de l'invention, en fonction de la polarisation à l'interface entre ladite couche ferromagnétique et ledit dispositif de détection d'une inhomogénéité magnétique.

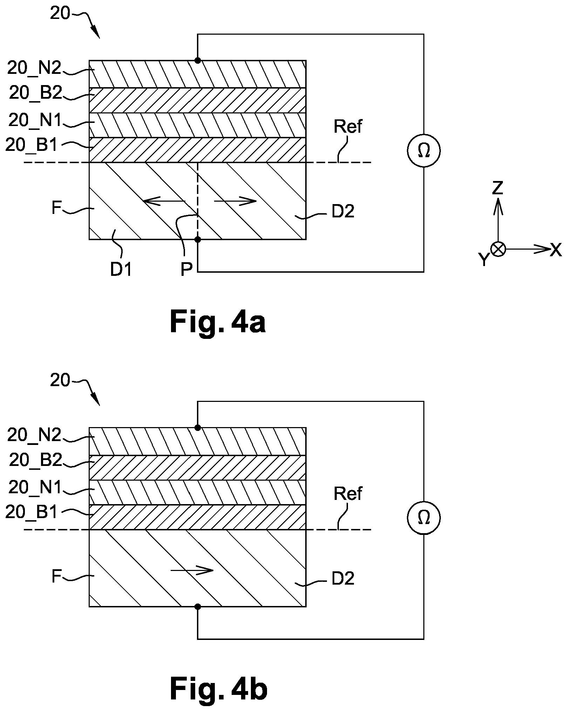

- La figure 4a montre schématiquement une première configuration d'un dispositif de détection d'une inhomogénéité magnétique dans un élément ferromagnétique, selon un deuxième mode de réalisation de l'invention.
- La figure 4b montre schématiquement une deuxième configuration du dispositif de la figure 4a, selon le deuxième mode de réalisation de l'invention.

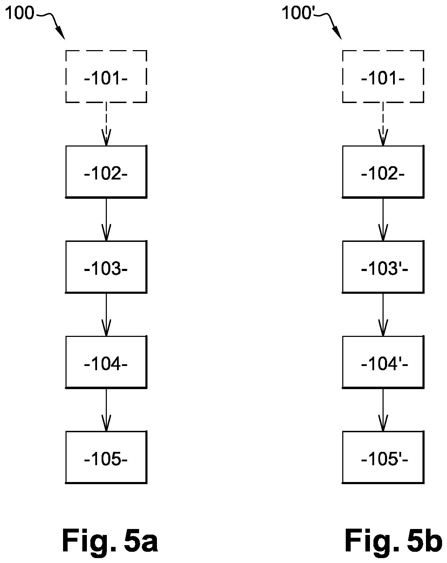

- La figure 5a montre schématiquement les étapes d'un procédé de détection d'une inhomogénéité magnétique dans un matériau ferromagnétique au moyen d'un dispositif de détection d'une inhomogénéité magnétique selon le premier ou le deuxième mode de réalisation de l'invention.
- La figure 5b montre schématiquement les étapes d'un procédé de détection d'une modification d'une configuration magnétique d'une inhomogénéité magnétique dans un matériau ferromagnétique au moyen d'un dispositif de détection d'une inhomogénéité magnétique selon le premier ou le deuxième mode de réalisation de l'invention.

## DESCRIPTION DETAILLEE D'AU MOINS UN MODE DE REALISATION DE L'INVENTION

Sauf précision contraire, un même élément apparaissant sur des figures différentes présente une référence unique.

Les figures 1a, 1b et 1c, qui montrent un dispositif selon l'état de la technique de détection d'une paroi magnétique dans un élément ferromagnétique par une mesure de magnétorésistance géante GMR ou tunnel TMR, ont été précédemment décrites.

Les figures 2a, 2a' et 2b, qui montrent un dispositif 10 de détection d'une inhomogénéité magnétique dans un élément ferromagnétique selon un premier mode de réalisation de l'invention, sont à présent décrites. Les figures 2a, 2a' et 2b sont décrites conjointement.

Les figures 2a, 2a' et 2b montrent une couche F d'un matériau ferromagnétique, également appelée « couche ferromagnétique ». Le dispositif 10 selon le premier mode de réalisation de l'invention permet de détecter une inhomogénéité magnétique P dans la couche ferromagnétique F. La figure 2a montre une première configuration inhomogène de la couche ferromagnétique F, et la figure 2a' montre une deuxième configuration inhomogène de la couche ferromagnétique F. Dans les configurations magnétiques inhomogènes particulières représentées aux figures 2a et 2a', la couche ferromagnétique F comporte une inhomogénéité magnétique P qui est une paroi magnétique, séparant un premier domaine magnétique D1 d'un deuxième domaine magnétique D2. Les moments magnétiques du premier domaine magnétique D1 sont tous orientés dans une même première direction. Les moments magnétiques du deuxième domaine magnétique D2 sont tous orientés dans une même deuxième direction, distincte de la première direction. A l'intérieur de la paroi magnétique, l'orientation des moments magnétiques varie progressivement, pour passer de la première direction du premier domaine D1 à la deuxième direction du deuxième domaine D2. Alternativement, l'inhomogénéité magnétique P peut par exemple être un skyrmion.

Le dispositif 10 selon le premier mode de réalisation de l'invention comporte :

- une couche barrière en matériau oxydé 10_B s'étendant sensiblement suivant un plan de référence Ref et apte à être agencée au contact d'au moins une partie de la couche ferromagnétique F. Les figures 2a et 2b montrent un exemple de réalisation dans lequel la couche barrière 10_B est agencée au contact de toute une face de la couche ferromagnétique F ;
- une couche 10_N d'un matériau non ferromagnétique, également appelée « couche non ferromagnétique », déposée sur la couche barrière 10_B et s'étendant sensiblement parallèlement au plan de référence Ref ;
- des moyens pour appliquer un courant traversant sensiblement perpendiculairement au plan de référence Ref l'empilement formé par :

  ◦ la couche ferromagnétique F dont on souhaite déterminer si elle comporte ou non une inhomogénéité magnétique, et
  ◦ la couche barrière 10_B et la couche non ferromagnétique 10_N ;

- des moyens pour mesurer la résistance électrique dudit empilement.

La figure 2c montre les dimensions typiques du dispositif 10 de détection selon le premier mode de réalisation de l'invention, qui est généralement en forme de ruban ou de barreau ou de pilier parallélépipédique et présente :

- une épaisseur E_B de la couche barrière 10_B, mesurée selon un axe Z perpendiculaire au plan de référence Ref, typiquement de l'ordre du nanomètre et inférieure à 5 nm ;
- une épaisseur E_N de la couche non magnétique 10_N, mesurée selon l'axe Z, typiquement comprise entre quelques nanomètres et quelques dizaines de nanomètres ;
- une largeur L, mesurée suivant un axe X, typiquement submicronique, et une longueur l, mesurée suivant un axe Y, typiquement submicronique : la largeur L et la longueur l sont choisies en fonction du paramètre de longueur de diffusion de spin du matériau non magnétique et des dimensions de l'inhomogénéité magnétique à détecter. La largeur L et la longueur l sont typiquement inférieures à au moins trois fois la longueur de diffusion de spin, soit dans le cas de matériaux tels que Al, Cu inférieures à environ 1200 nm, et supérieures à la taille de l'inhomogénéité à détecter, qui est typiquement de 1 à 20 nm pour les parois et les skyrmions.

La couche ferromagnétique F présente une épaisseur, mesurée suivant l'axe Z, typiquement comprise entre 0,3 et 100 nm.
Les axes X, Y et Z forment un repère orthogonal.
Un exemple particulier de dimensionnement est à présent décrit, à titre indicatif. Le dispositif 10 peut ainsi comporter :

- une couche ferromagnétique F en Co/Pt de 0,5 nm d'épaisseur, 10 nm de long et 10 nm de large ;
- une couche barrière 10_B en MgO de 1 nm d'épaisseur, 10 nm de long et 10 nm de large ;
- une couche 10_N non ferromagnétique en Cu de 30 nm d'épaisseur, 10 nm de long et 10 nm de large.

Le dispositif 10 de détection peut également être en forme de section cylindrique ou elliptique.
La couche barrière 10_B est avantageusement réalisée en oxyde de magnésium MgO, ou alternativement en oxyde d'aluminium $Al_2O_3$ ou en oxyde d'hafnium $HfO_2$ ou en oxyde de titanate de strontium $SrTiO_3$. La couche barrière 10_B présente une résistance notée Rb.
La couche ferromagnétique F, dans laquelle la présence ou l'absence d'une inhomogénéité magnétique est détectée, est avantageusement choisie afin de maximiser la polarisation $\gamma$ à l'interface avec la couche barrière 10_B. On utilise ainsi avantageusement, avec une couche barrière 10_B en oxyde de magnésium MgO ou alternativement en $Al_2O_3$, $HfO_2$ ou $SrTiO_3$, une couche ferromagnétique F en un alliage de cobalt, de fer et de bore CoFeB, ou en un alliage de cobalt et de fer CoFe, ou en cobalt Co, ou en un alliage de nickel et de fer NiFe. Alternativement, la couche ferromagnétique F peut également être une multicouche de type Co/Pt ou Co/Ni, ou un alliage de Heusler.

La polarisation à l'interface entre une couche ferromagnétique F en CoFeB et une couche barrière 10_B en MgO est de l'ordre de 80%. La polarisation à l'interface entre une couche ferromagnétique F en CoFeB et une couche barrière 10_B en $Al_2O_3$ est de l'ordre de 30%. La couche 10_N non ferromagnétique est avantageusement choisie de manière à présenter une résistance, notée Rn, supérieure ou égale à 1% de la résistance Rb de la couche barrière 10_B: $Rn \geq Rb/100$. La couche 10_N non ferromagnétique est avantageusement choisie de manière à présenter une résistance Rn supérieure ou égale à 10% de la résistance Rb de la couche barrière 10_B : $Rn \geq Rb/10$.

Lorsqu'un courant est appliqué, sensiblement perpendiculairement au plan de référence Ref, à travers l'empilement formé par la couche ferromagnétique F à tester, la couche barrière 10_B et la couche 10_N non ferromagnétique, une variation de la résistance totale de l'empilement est observée, en fonction de la présence ou de l'absence d'une inhomogénéité magnétique, telle qu'une paroi magnétique ou un skyrmion, dans la couche ferromagnétique F. Dans la configuration magnétique homogène représentée à la figure 2b, la couche ferromagnétique F présente une aimantation homogène et une accumulation de spin se forme au voisinage de l'interface entre la couche ferromagnétique F et la couche barrière 10_B et au voisinage de l'interface entre la couche barrière 10_B et la couche 10_N non ferromagnétique, qui crée une résistance additionnelle de l'empilement. Dans la première configuration magnétique inhomogène particulière représentée à la figure 2a et dans la deuxième configuration magnétique inhomogène particulière représentée à la figure 2a', la présence de la paroi magnétique P dans la couche ferromagnétique F réduit l'accumulation de spin précédemment formée ainsi que la résistance additionnelle de l'empilement. La résistance électrique totale de l'empilement selon le premier mode de réalisation varie donc, selon qu'une inhomogénéité magnétique est présente ou non dans la couche ferromagnétique F. Lorsqu'une inhomogénéité magnétique est présente dans la couche ferromagnétique F, l'empilement présente une résistance qui est inférieure à la résistance de l'empilement lorsqu'aucune inhomogénéité magnétique n'est présente dans la couche ferromagnétique F. La variation de résistance de l'empilement selon le premier mode de réalisation peut atteindre 25%, et être typiquement de l'ordre de plusieurs centaines d'Ohms. L'expression théorique de la variation maximale de résistance ΔR/R de l'empilement selon le premier mode de réalisation s'exprime sous la forme :

$$\frac{\Delta R}{R} \sim \frac{\gamma^2}{4} \ si \ Rn \sim Rb$$

ou

$$\frac{\Delta R}{R} \sim \frac{Rn \times \gamma^2}{Rb} \ si \ Rn \ll Rb$$

Il est connu que la résistance de la seule couche ferromagnétique F présente déjà une dépendance avec la configuration micromagnétique de ladite couche ferromagnétique F, en raison de deux effets. Le premier de ces effets est la magnétorésistance anisotrope AMR : la résistivité de la couche ferromagnétique F dépend localement de la différence relative d'orientation entre son aimantation et son vecteur densité de courant. Le deuxième effet est la magnétorésistance de paroi DWR : lorsqu'une paroi magnétique est introduite dans la couche ferromagnétique F, la résistance de la couche ferromagnétique F varie dans le volume de la paroi magnétique. Toutefois, ces deux effets ont uniquement lieu dans le volume de la couche ferromagnétique F et ne dépendent donc pas de la nature des couches adjacentes et des interfaces entre la couche ferromagnétique F et lesdites couches adjacentes. Ces deux effets sont en outre relativement faibles : ils ne peuvent entraîner qu'une variation de résistance de la couche ferromagnétique F inférieure à 10%, typiquement de l'ordre de l'Ohm. En comparaison, la résistance totale de l'empilement formé par la couche ferromagnétique F, la couche barrière 10_B et la couche 10_N non ferromagnétique est dominée par la somme des résistances de la couche barrière 10_B et de la couche 10_N non ferromagnétique, qui est typiquement cent fois supérieure à celle de la couche ferromagnétique F. Dans un tel empilement, les variations de résistance de la couche ferromagnétique F dues aux effets de magnétorésistance anisotrope AMR et/ou aux effets de magnétorésistance de paroi DWR sont donc négligeables, c'est-à-dire typiquement inférieures à 0,1 %,

La figure 3 montre une simulation numérique de la variation relative de la résistance de l'empilement formé par la couche ferromagnétique F, la couche barrière 10_B et la couche non ferromagnétique 10_N, en fonction de la polarisation à l'interface entre la couche ferromagnétique F et la couche barrière 10_B.

Les figures 4a et 4b, qui montrent un dispositif 20 de détection d'une inhomogénéité magnétique dans un élément ferromagnétique selon un deuxième mode de réalisation de l'invention, sont à présent décrites. Les figures 4a et 4b sont décrites conjointement.

Les figures 4a et 4b montrent la couche F ferromagnétique, précédemment décrite en lien avec les figures 2a et 2b. Le dispositif 20 selon le deuxième mode de réalisation de l'invention permet de détecter une inhomogénéité magnétique P dans la couche ferromagnétique F, telle qu'une paroi magnétique ou un skyrmion. Le dispositif 20 selon le deuxième mode de réalisation de l'invention comporte :

- une première couche barrière en matériau oxydé 20_B1 s'étendant sensiblement suivant le plan de référence Ref et apte à être agencée au contact d'au moins une partie de la couche ferromagnétique F. Les figures 4a et 4b montrent un exemple de réalisation dans lequel la première couche barrière 20_B1 est agencée au contact de toute une face de la couche ferromagnétique F ;
- une première couche 20_N1 d'un matériau non ferromagnétique, également appelée « première couche non ferromagnétique », déposée sur la première couche barrière 20_B1 et s'étendant sensiblement parallèlement au plan de référence Ref ;
- une deuxième couche barrière en matériau oxydé 20_B2, déposée sur la première couche 20_N1 non ferromagnétique et s'étendant sensiblement parallèlement au plan de référence Ref ;
- une deuxième couche 20_N2 d'un matériau non ferromagnétique, également appelée « deuxième couche non ferromagnétique », déposée sur la deuxième couche barrière 20_B2 et s'étendant sensiblement parallèlement au plan de référence Ref ;
- des moyens pour appliquer un courant traversant sensiblement perpendiculairement au plan de référence Ref l'empilement formé par :

  ◦ la couche ferromagnétique F dont on souhaite déterminer si elle comporte ou non une inhomogénéité magnétique, et
  ◦ la première couche barrière 20_B1, la première couche non ferromagnétique 20_N1, la deuxième couche barrière 20_B2 et la deuxième couche non ferromagnétique 20_N2 ;

- des moyens pour mesurer la résistance électrique dudit empilement.

Le dispositif 20 selon le deuxième mode de réalisation de l'invention présente généralement :

- une épaisseur de la première couche barrière 20_B1, mesurée selon l'axe Z perpendiculaire au plan de référence Ref, typiquement de l'ordre du nanomètre et inférieure à 5 nm ;
- une épaisseur de la deuxième couche barrière 20_B2, mesurée selon l'axe Z, typiquement de l'ordre du nanomètre et inférieure à 5 nm ;
- une épaisseur de la première couche non ferromagnétique 20_N1, mesurée selon l'axe Z, typiquement comprise entre 0,5 nm et quelques dizaines de nanomètres ;
- une épaisseur de la deuxième couche non ferromagnétique 20_N2, mesurée selon l'axe Z, typiquement supérieure au nanomètre ;
- de manière analogue au premier mode de l'invention précédemment décrit, une largeur mesurée suivant l'axe X typiquement submicronique, et une longueur mesurée suivant l'axe Y typiquement submicronique, la largeur et la longueur étant choisies en fonction du paramètre de longueur de diffusion de spin du matériau non magnétique et des dimensions de l'inhomogénéité magnétique à détecter. La longueur et la largeur du dispositif 20 sont typiquement inférieures à au moins trois fois la longueur de diffusion de spin, et supérieures à la taille de l'inhomogénéité.

La couche ferromagnétique F présente typiquement une épaisseur, mesurée suivant l'axe Z, comprise entre 0,3 et 100 nm.

La première couche barrière 20_B1 et la deuxième couche barrière 20_B2 sont avantageusement réalisées en oxyde de magnésium MgO, ou alternativement en oxyde d'aluminium $Al_2O_3$ ou en oxyde d'hafnium $HfO_2$ ou en oxyde de titanate de strontium $SrTiO_3$. La première couche barrière 20_B1 et la deuxième couche barrière 20_B2 peuvent être réalisées dans le même matériau. Alternativement, la première couche barrière 20_B1 peut être réalisée dans un matériau différent du matériau de la deuxième couche barrière 20_B2. La première couche barrière 20_B1 est choisie pour maximiser la polarisation qui dépend de l'interface entre la couche ferromagnétique F et ladite première couche barrière 20_B1. La deuxième couche barrière 20_B2 permet de confiner l'accumulation de spins entre les deux couches barrières. La présence d'au moins deux couches barrières dans le dispositif 20 selon le deuxième mode de réalisation de l'invention permet également de relâcher les contraintes sur les valeurs de résistance des première et deuxième couches non ferromagnétique 20_N1 et 20_N2, par rapport aux valeurs de résistance des première et deuxième couches barrières 20_B1 et 20_B2.

De même que précédemment décrit pour le premier mode de réalisation de l'invention, en lien avec les figures 2a et 2b, la couche ferromagnétique F, dans laquelle la présence ou l'absence d'une inhomogénéité magnétique est détectée, est avantageusement choisie afin de maximiser la polarisation $\gamma$ à l'interface avec la première couche barrière 20_B1.

On utilise ainsi avantageusement, avec une première couche barrière 20_B1 en oxyde de magnésium MgO, une couche ferromagnétique F en un alliage de cobalt, de fer et de bore CoFeB, ou en un alliage de cobalt et de fer CoFe, ou en cobalt Co. Alternativement, la couche ferromagnétique F utilisée avec une première couche barrière 20_B1 en oxyde de magnésium MgO peut également être une multicouche de type Co/Pt ou Co/Ni, ou un alliage de Heusler.

La première couche 20_N1 non ferromagnétique et la deuxième couche 20_N2 non ferromagnétique sont avantageusement choisies de manière à présenter chacune une résistance inférieure à la résistance de la première couche barrière 20_B1 et de la deuxième couche barrière 20_B2. La première couche 20_N1 non ferromagnétique et la deuxième couche 20_N2 non ferromagnétique peuvent être réalisées dans le même matériau. Alternativement, la première couche 20_N1 non ferromagnétique peut être réalisée dans un matériau différent du matériau de la deuxième couche 20_N2 non ferromagnétique.

De manière analogue à ce qui a été précédemment décrit pour le premier mode de réalisation de l'invention, la résistance électrique totale de l'empilement selon le deuxième mode de réalisation varie selon qu'une inhomogénéité magnétique est présente ou non dans la couche ferromagnétique F. Lorsqu'une inhomogénéité magnétique est présente dans la couche ferromagnétique F, l'empilement présente une résistance qui est inférieure à la résistance de l'empilement lorsqu'aucune inhomogénéité magnétique n'est présente dans la couche ferromagnétique F. La variation de résistance de l'empilement selon le deuxième mode de réalisation peut atteindre 50%, et être typiquement de l'ordre de plusieurs centaines d'Ohms. L'expression théorique de la variation relative maximale de résistance $\Delta R/R$ de l'empilement selon le deuxième mode de réalisation, dans le cas où les deux couches barrières 20_B1 et 20_B2 sont réalisées en matériau identique et où les deux couches non ferromagnétiques 20_N1 et 20_N2 sont réalisées en un matériau identique, s'exprime sous la forme :

$$\frac{\Delta R}{R} \sim \frac{\gamma^2}{2(2-\gamma^2)} \; \text{dès lors que } Rn1 \; < Rb \text{ et } Rn2 \; < \; Rb$$

avec Rn1 la résistance de la première couche non ferromagnétique 20_N1 et Rn2 la résistance de la deuxième couche non ferromagnétique 20_N2, et Rb la résistance de la première couche barrière 20_B1 et de la deuxième couche barrière 20_B2.

La figure 5a montre schématiquement les étapes d'un procédé 100 de détection d'une inhomogénéité magnétique dans un matériau ferromagnétique au moyen d'un dispositif de détection d'une inhomogénéité magnétique selon le premier ou le deuxième mode de réalisation de l'invention.

Le procédé 100 selon un aspect de l'invention comporte les étapes suivantes :

- une étape 102 selon laquelle un courant est appliqué, qui traverse, sensiblement perpendiculairement au plan de référence Ref, l'empilement formé par la couche F du matériau ferromagnétique et :

   ◦ la couche barrière 10_B et la couche non ferromagnétique 10_N, dans le cas du dispositif 10 de détection selon le premier mode de réalisation de l'invention, ou
   ◦ la première couche barrière 20_B1, la première couche non ferromagnétique 20_N1, la deuxième couche barrière 20_B2 et la deuxième couche non ferromagnétique 20_N2 dans le cas du dispositif 20 de détection selon le deuxième mode de réalisation de l'invention ;

- une étape 103 selon laquelle la résistance dudit empilement est mesurée ;
- une étape 104 selon laquelle la résistance précédemment mesurée est comparée avec une résistance de référence, la résistance de référence étant la résistance dudit empilement en l'absence d'inhomogénéité magnétique dans la couche F du matériau ferromagnétique ;
- une étape 105 selon laquelle la présence d'une inhomogénéité magnétique dans la couche F du matériau ferromagnétique est détectée si la résistance mesurée est inférieure à la résistance de référence, ou selon laquelle l'absence d'inhomogénéité magnétique dans la couche F du matériau ferromagnétique est détectée si la résistance mesurée est supérieure à la résistance de référence.

Le procédé 100 de détection d'une inhomogénéité magnétique dans un matériau ferromagnétique peut également comporter, préalablement aux étapes 102, 103, 104 et 105 qui viennent d'être décrites, une étape 101 selon laquelle le dispositif 10 de détection selon le premier mode de réalisation, ou le dispositif 20 de détection selon le deuxième mode de réalisation, est agencé de manière que la couche barrière 10_B du dispositif 10 selon le premier mode de réalisation de l'invention, ou la première couche barrière 20_B1 du dispositif 20 selon le deuxième mode de réalisation, s'étende au contact d'au moins une partie de la couche F du matériau ferromagnétique.

La figure 5b montre schématiquement les étapes d'un procédé 100' de détection d'une modification d'une configuration magnétique d'une inhomogénéité magnétique dans un matériau ferromagnétique au moyen d'un dispositif de détection d'une inhomogénéité magnétique selon le premier ou le deuxième mode de réalisation de l'invention.

Le procédé 100' comporte :

- l'étape 102 précédemment décrite, selon laquelle un courant est appliqué, qui traverse, sensiblement perpendiculairement au plan de référence Ref, l'empilement formé par la couche F du matériau ferromagnétique et :

  ◦ la couche barrière 10_B et la couche non ferromagnétique 10_N, dans le cas du dispositif 10 de détection selon le premier mode de réalisation de l'invention, ou
  ◦ la première couche barrière 20_B1, la première couche non ferromagnétique 20_N1, la deuxième couche barrière 20_B2 et la deuxième couche non ferromagnétique 20_N2 dans le cas du dispositif 20 de détection selon le deuxième mode de réalisation de l'invention ;

- une étape 103' selon laquelle une première résistance dudit empilement est mesurée à un premier instant et une deuxième résistance dudit empilement est mesurée à un deuxième instant différent du premier instant ;
- une étape 104' selon laquelle les première et deuxième résistances précédemment mesurées sont comparées ;
- une étape 105' selon laquelle selon laquelle une modification de la configuration magnétique de l'inhomogénéité magnétique est détectée si les première et deuxième résistances sont distinctes l'une de l'autre et si les première et deuxième résistances sont inférieures à une résistance de référence mesurée en l'absence d'inhomogénéité magnétique dans la couche F du matériau ferromagnétique.

Le procédé 100' de détection d'une modification d'une configuration magnétique d'une inhomogénéité magnétique dans un matériau ferromagnétique peut également comporter, préalablement aux étapes 102, 103', 104' et 105' qui viennent d'être décrites, l'étape 101 précédemment décrite.

## Revendications

1. Dispositif (20) de détection d'une inhomogénéité magnétique dans un matériau ferromagnétique **caractérisé en ce qu'**il comporte :

   - une première couche barrière en matériau oxydé (20_B1) s'étendant sensiblement suivant un plan de référence (Ref) et apte à être agencée au contact d'au moins une partie d'une couche (F) du matériau ferromagnétique ;
   - une première couche (20_N1) d'un matériau non ferromagnétique déposée sur la première couche barrière (20_B1) et s'étendant sensiblement parallèlement au plan de référence ;
   - une deuxième couche barrière (20_B2) déposée sur la première couche (20_N1) d'un matériau non ferromagnétique et s'étendant sensiblement parallèlement au plan de référence (Ref) ;
   - une deuxième couche (20_N2) d'un matériau non ferromagnétique déposée sur la deuxième couche barrière (20_B2) et s'étendant sensiblement parallèlement au plan de référence ;
   - des moyens pour appliquer un courant traversant sensiblement perpendiculairement au plan de référence l'empilement formé par la couche (F) du matériau ferromagnétique, la première couche barrière (20_B1), la première couche (20_N1) d'un matériau non ferromagnétique, la deuxième couche barrière (20_B2) et la deuxième couche (20_N2) d'un matériau non ferromagnétique ;
   - des moyens pour mesurer la résistance électrique dudit empilement.

2. Dispositif (20) de détection d'une inhomogénéité magnétique dans un matériau ferromagnétique selon la revendication précédente **caractérisé en ce que** la première couche barrière (20_B1) est réalisée en oxyde de magnésium MgO ou en oxyde d'aluminium $Al_2O_3$ ou en oxyde d'hafnium $HfO_2$ ou en oxyde de titanate de strontium $SrTiO_3$.

3. Dispositif (20) de détection d'une inhomogénéité magnétique dans un matériau ferromagnétique selon la revendication précédente **caractérisé en ce que** la couche (F) du matériau ferromagnétique est réalisée en un alliage de cobalt, de fer et de bore CoFeB, ou en un alliage de cobalt et de fer CoFe, ou en cobalt Co, ou en un alliage de nickel et de fer NiFe.

4. Dispositif (20) de détection d'une inhomogénéité magnétique dans un matériau ferromagnétique selon la revendication 2 **caractérisé en ce que** la couche (F) du matériau ferromagnétique est une multicouche de type Co/Pt ou Co/Ni, ou un alliage de Heusler.

**5.** Procédé (100) de détection d'une inhomogénéité magnétique dans un matériau ferromagnétique au moyen d'un dispositif (20) de détection d'une inhomogénéité magnétique selon l'une quelconque des revendications précédentes, comportant les étapes suivantes :

- appliquer (102) un courant traversant, sensiblement perpendiculairement au plan de référence (Ref), l'empilement formé par la couche (F) du matériau ferromagnétique et le dispositif (20) de détection d'une inhomogénéité magnétique ;
- mesurer (103) la résistance dudit empilement ;
- comparer (104) la résistance précédemment mesurée avec une résistance de référence, la résistance de référence étant la résistance dudit empilement en l'absence d'inhomogénéité magnétique dans la couche (F) du matériau ferromagnétique ;
- détecter (105) la présence d'une inhomogénéité magnétique dans la couche (F) du matériau ferromagnétique si la résistance mesurée est inférieure à la résistance de référence.

**6.** Procédé (100) de détection d'une inhomogénéité magnétique dans un matériau ferromagnétique selon la revendication précédente caractérisé en en ce qu'il comporte une étape (101) d'agencement du dispositif (20) de détection d'une inhomogénéité magnétique de manière que la première couche barrière (20_B1) du dispositif de détection d'une inhomogénéité magnétique s'étende au contact d'au moins une partie d'une couche (F) du matériau ferromagnétique.

**7.** Procédé (100') de détection d'une modification d'une configuration magnétique d'une inhomogénéité magnétique dans un matériau ferromagnétique au moyen d'un dispositif (20) de détection d'une inhomogénéité magnétique selon l'une quelconque des revendications 1 à 4, comportant les étapes suivantes :

- appliquer (102) un courant traversant, sensiblement perpendiculairement au plan de référence (Ref), l'empilement formé par la couche (F) du matériau ferromagnétique et le dispositif (20) de détection d'une inhomogénéité magnétique ;
- mesurer (103') une première résistance dudit empilement à un premier instant et une deuxième résistance dudit empilement à un deuxième instant différent du premier instant ;
- comparer (104') les première et deuxième résistances ;
- détecter (105') une modification de la configuration magnétique de l'inhomogénéité magnétique si les première et deuxième résistances sont distinctes l'une de l'autre.

**8.** Procédé (100, 100') de détection d'une inhomogénéité magnétique ou d'une modification d'une configuration magnétique d'une inhomogénéité magnétique dans un matériau ferromagnétique selon l'une quelconque des revendications 6 ou 7 caractérisé en en ce qu'il comporte une étape (101) d'agencement du dispositif (20) de détection d'une inhomogénéité magnétique ou d'une modification d'une configuration magnétique d'une inhomogénéité magnétique de manière que la première couche barrière (20_B1) du dispositif de détection d'une inhomogénéité magnétique s'étende au contact d'au moins une partie d'une couche (F) du matériau ferromagnétique.

**Patentansprüche**

**1.** Erfassungsvorrichtung (20) einer magnetischen Inhomogenität in einem ferromagnetischen Material, **dadurch gekennzeichnet, dass** sie umfasst:

- eine erste Sperrschicht aus oxidiertem Material (20_B1), die sich deutlich gemäß einer Referenzebene (Ref) erstreckt und geeignet ist, in Kontakt mit wenigstens einem Teil einer Schicht (F) des ferromagnetischen Materials angeordnet zu sein;
- eine erste Schicht (20_N1) eines nicht ferromagnetischen Materials, das auf der ersten Sperrschicht (20_B1) aufgebracht ist und sich deutlich parallel zur Referenzebene erstreckt;
- eine zweite Sperrschicht (20_B2), die auf der ersten Schicht (20_N1) eines nicht ferromagnetischen Materials aufgebracht ist und sich deutlich parallel zur Referenzebene (Ref) erstreckt;
- eine zweite Schicht (20_N2) eines nicht ferromagnetischen Materials, das auf der zweiten Sperrschicht (20_B2) aufgebracht ist und sich deutlich parallel zur Referenzebene erstreckt;
- Mittel zum Anwenden eines deutlich lotrecht zur Referenzebene die durch die Schicht (F) des ferromagnetischen Materials, die erste Sperrschicht (20_B1), die erste Schicht (20_N1) eines nicht ferromagnetischen Materials, die zweite Sperrschicht (20_B2) und die zweite Schicht (20_N2) eines nicht ferromagnetischen Materials gebildete Stapelung durchquerenden Stroms;
- Mittel zur Messung des elektrischen Widerstandes der genannten Stapelung.

2. Erfassungsvorrichtung (20) einer magnetischen Inhomogenität in einem ferromagnetischen Material gemäß dem voranstehenden Anspruch, **dadurch gekennzeichnet, dass** die erste Sperrschicht (20_B1) aus Magnesiumoxid MgO oder aus Aluminiumoxid $Al_2O_3$ oder aus Hafniumoxid $HfO_2$ oder aus Strontiumtitanoxid $SrTiO_3$ realisiert ist.

3. Erfassungsvorrichtung (20) einer magnetischen Inhomogenität aus ferromagnetischem Material gemäß dem voranstehenden Anspruch, **dadurch gekennzeichnet, dass** die Schicht (F) des ferromagnetischen Materials aus einer Kobalt-, Eisen-, und Borlegierung CoFeB oder aus einer Kobalt- und Eisenlegierung CoFe oder aus Kobalt Co oder aus einer Nickel- und Eisenlegierung NiFe realisiert ist.

4. Erfassungsvorrichtung (20) einer magnetischen Inhomogenität in einem ferromagnetischen Material gemäß Anspruch 2, **dadurch gekennzeichnet, dass** die Schicht (F) des ferromagnetischen Materials eine mehrschichtige Schicht vom Typ Co/Pt oder Co/Ni oder eine Heusler-Legierung ist.

5. Erfassungsverfahren (100) einer magnetischen Inhomogenität aus einem ferromagnetischen Material mittels einer Erfassungsvorrichtung (20) einer magnetischen Inhomogenität gemäß irgendeinem der voranstehenden Ansprüche, umfassend die folgenden Schritte:

   - Anwenden (102) eines die durch die Schicht (F) des ferromagnetischen Materials und die Erfassungsvorrichtung (20) einer magnetischen Inhomogenität gebildeten Stapelung durchquerenden Stroms deutlich lotrecht zur Referenzebene (Ref);
   - Messen (103) des Widerstandes der genannten Stapelung;
   - Vergleichen (104) des zuvor gemessenen Widerstandes mit einem Referenzwiderstand, wobei der Referenzwiderstand der Widerstand der genannten Stapelung bei Fehlen der magnetischen Inhomogenität in der Schicht (F) des ferromagnetischen Materials ist;
   - Erfassen (105) des Vorhandenseins einer magnetischen Inhomogenität in der Schicht (F) des ferromagnetischen Materials, wenn der gemessene Widerstand geringer ist als der Referenzwiderstand.

6. Erfassungsverfahren (100) einer magnetischen Inhomogenität in einem ferromagnetischen Material gemäß dem voranstehenden Anspruch, **dadurch gekennzeichnet, dass** es einen Anordnungsschritt (101) der Erfassungsvorrichtung (20) einer magnetischen Inhomogenität derart umfasst, dass die erste Sperrschicht (20_B1) der Erfassungsvorrichtung einer magnetischen Inhomogenität sich im Kontakt mit wenigstens einem Teil einer Schicht (F) des ferromagnetischen Materials erstreckt.

7. Erfassungsverfahren (100) einer Änderung einer magnetischen Konfiguration einer magnetischen Inhomogenität in einem ferromagnetischen Material mittels einer Erfassungsvorrichtung (20) einer magnetischen Inhomogenität gemäß irgendeinem der Ansprüche 1 bis 4, umfassend die folgenden Schritte:

   - Anwenden (102) eines deutlich lotrecht zur Referenzebene (Ref) die durch die Schicht (F) des ferromagnetischen Materials und die Erfassungsvorrichtung (20) einer magnetischen Inhomogenität gebildeten Stapelung durchquerenden Stroms;
   - Messen (103') eines ersten Widerstandes der genannten Stapelung zu einem ersten Moment und eines zweiten Widerstandes der genannten Stapelung zu einem zweiten, vom ersten Moment unterschiedlichen Moment;
   - Vergleichen (104') der ersten und zweiten Widerstände;
   - Erfassen (105') einer Änderung der magnetischen Konfiguration der magnetischen Inhomogenität, wenn der erste und zweite Widerstand voneinander unterschiedlich sind.

8. Erfassungsverfahren (100, 100') einer magnetischen Inhomogenität oder einer Änderung einer magnetischen Konfiguration einer magnetischen Inhomogenität in einem ferromagnetischen Material gemäß irgendeinem der Ansprüche 6 oder 7, **dadurch gekennzeichnet, dass** es einen Anordnungsschritt (101) der Erfassungsvorrichtung (20) einer magnetischen Inhomogenität oder einer Änderung einer magnetischen Konfiguration einer magnetischen Inhomogenität derart umfasst, dass die erste Sperrschicht (20_B1) der Erfassungsvorrichtung einer magnetischen Inhomogenität sich im Kontakt mit wenigstens einem Teil einer Schicht (F) des ferromagnetischen Materials erstreckt.

**Claims**

1. Device (20) for detecting a magnetic inhomogeneity in a ferromagnetic material **characterised in that** it comprises:

   - a first barrier layer of oxidised material (20_B1) extending substantially along a plane of reference (Ref) and adapted to be arranged in contact with at least a portion of a layer (F) of the ferromagnetic material;
   - a first layer (20_N1) of a non-ferromagnetic material deposited on the first barrier layer (20_B1) and extending substantially parallel to the reference plane;
   - a second barrier layer (20_B2) deposited on the first layer (20_N1) of a non-ferromagnetic material and extending substantially parallel to the reference plane (Ref) ;
   - a second layer (20_N2) of a non-ferromagnetic material deposited on the second barrier layer (20_B2) and extending substantially parallel to the reference plane;
   - means for applying a current substantially perpendicular to the reference plane through the stack formed by the layer (F) of the ferromagnetic material, the first barrier layer (20_B1), the first layer (20_N1) of a non-ferromagnetic material, the second barrier layer (20_B2) and the second layer (20_N2) of a non-ferromagnetic material;
   - means for measuring the electrical resistance of said stack.

2. Device (20) for detecting a magnetic inhomogeneity in a ferromagnetic material as claimed in the preceding claim **characterised in that** the first barrier layer (20_B1) is made from magnesium oxide MgO or from aluminium oxide $Al_2O_3$ or from hafnium oxide $HfO_2$ or from strontium titanate oxide $SrTiO_3$.

3. Device (20) for detecting a magnetic inhomogeneity in a ferromagnetic material as claimed in the preceding claim **characterised in that** the layer (F) of the ferromagnetic material is made from an alloy of cobalt, iron and boron CoFeB, or from an alloy of cobalt and iron CoFe, or from cobalt Co, or from an alloy of nickel and iron NiFe.

4. Device (20) for detecting a magnetic inhomogeneity in a ferromagnetic material according to claim 2 **characterised in that** the layer (F) of the ferromagnetic material is a multilayer of the Co/Pt or Co/Ni type, or a Heusler alloy.

5. Method (100) for detecting a magnetic inhomogeneity in a ferromagnetic material by means of a device (20) for detecting a magnetic inhomogeneity as claimed in any preceding claim, comprising the following steps:

   - applying (102) a current substantially perpendicular to the reference plane (Ref) through the stack formed by the layer (F) of the ferromagnetic material and the device (20) for detecting a magnetic inhomogeneity;
   - measuring (103) the resistance of said stack;
   - comparing (104) the previously measured resistance with a reference resistance, with the reference resistance being the resistance of said stack in the absence of magnetic inhomogeneity in the layer (F) of the ferromagnetic material;
   - detecting (105) the presence of a magnetic inhomogeneity in the layer (F) of the ferromagnetic material if the resistance measured is less than the reference resistance.

6. Method (100) for detecting a magnetic inhomogeneity in a ferromagnetic material as claimed in the preceding claim **characterised in that** it comprises a step (101) of arranging the device (20) for detecting a magnetic inhomogeneity in such a way that the first barrier layer (20_B1) of the device for detecting a magnetic inhomogeneity extends in contact with at least a portion of a layer (F) of the ferromagnetic material.

7. Method (100') for detecting a modification of a magnetic configuration of a magnetic inhomogeneity in a ferromagnetic material by means of a device (20) for detecting a magnetic inhomogeneity according to any of claims 1 to 4, comprising the following steps:

   - applying (102) a current substantially perpendicular to the reference plane (Ref) through the stack formed by the layer (F) of the ferromagnetic material and the device (20) for detecting a magnetic inhomogeneity;
   - measuring (103') a first resistance of said stack at a first instant and a second resistance of said stack at a second instant that is different from the first instant;
   - comparing (104') the first and second resistances;
   - detecting (105') a modification in the magnetic configuration of the magnetic inhomogeneity if the first and second resistances are separate from one another.

8. Method (100, 100') for detecting a magnetic inhomogeneity or a modification of a magnetic configuration of a magnetic inhomogeneity in a ferromagnetic material according to any of claims 6 or 7 **characterised in that** it comprises a step (101) of arranging the device (20) for detecting a magnetic inhomogeneity or a modification of a magnetic configuration of a magnetic inhomogeneity in such a way that the first barrier layer (20_B1) of the device for detecting a magnetic inhomogeneity extends in contact with at least a portion of a layer (F) of the ferromagnetic material.

**Fig. 1a**

**Fig. 1b**

**Fig. 1c**

**Fig. 2a**

**Fig. 2a'**

**Fig. 2b**

**Fig. 2c**

**Fig. 3**

20

20_N2
20_B2
20_N1
20_B1

Ref

Ω

F

D2

D1      P

Z
↑
Y⊗ →X

# Fig. 4a

20

20_N2
20_B2
20_N1
20_B1

Ref

Ω

F

D2

# Fig. 4b

100

-101-

-102-

-103-

-104-

-105-

## Fig. 5a

100'

-101-

-102-

-103'-

-104'-

-105'-

## Fig. 5b